# EUROPEAN PATENT APPLICATION

(11) **EP 4 184 571 A1**
(43) Date of publication of application: **24.05.2023**
(21) Application number: 21208927.0
(22) Date of filing: 18.11.2021
(51) Int. Cl.: H01L 23/495

(54) **A SEMICONDUCTOR PACKAGE WITH IMPROVED CONNECTION OF THE PINS TO THE BOND PADS OF THE SEMICONDUCTOR DIE**

(71) Applicant: Nexperia B.V., 6534 AB Nijmegen (NL)
(72) Inventor: Yandoc, Ricardo, 6534 AB Nijmegen (NL); Brown, Adam, 6534 AB Nijmegen (NL); Fan, Haibo, 6534 AB Nijmegen (NL)
(74) Representative: Pjanovic, Ilija

(57) **Abstract**

A semiconductor package comprising a semiconductor die having multiple bond pads, said package further comprising an electrically conducting clip, wherein said clip comprises, at a first side thereof, at least one pin for mounting said package to an external board and comprises, at a second side opposite to said first side, a connecting portion connecting said clip to at least two bond pads of said multiple bond pads, said connection portion comprising:
- at least two elongated connecting strips spaced apart from each other at a distance in such a manner that each strip extends over at least one of said at least two bond pads and is connected thereto.

## Description

### Technical field

The present disclosure generally relates to the field of semiconductor packages and, more specifically, to an improved way of connecting the at least one pin to the bond pads of the semiconductor die.

### Background

A semiconductor package may be considered as a casing that comprises a semiconductor die or integrated circuits. The casing may be made of any type of material like plastic, glass or ceramics. Typically, individual components may be fabricated on so-called semiconductor wafers, for example silicon, before they are sliced into dies and packaged.

The semiconductor die provides for means for connecting the packaged semiconductor die to the external environment, for example a Printed Circuit Board, PCB. This is accomplished by leads such as lands, balls and/or pins. Further, the package may protect the semiconductor die against all kinds of threats, like mechanical impact, contamination and light exposure. Finally, the package may help dissipate heat produced by the device.

One of the downsides of the above described means is that they are prone to failures, resulting in a shorter life expectancy of the corresponding semiconductor package.

### Summary

It is an object of the present disclosure to provide for a semiconductor package having resilient, long-lasting, connection means between the pins of the semiconductor package and the bond pads on the semiconductor die.

It is a further object of the present disclosure to provide for an associated method for manufacturing a semiconductor package.

In a first aspect, there is provided a semiconductor package comprising a semiconductor die having multiple bond pads, said package further comprising an electrically conducting clip, wherein said clip comprises, at a first side thereof, at least one pin for mounting said package to an external board and comprises, at a second side opposite to said first side, a connecting portion connecting said clip to at least two bond pads of said multiple bond pads, said connection portion comprising:
- at least two elongated connecting strips spaced apart from each other at a distance in such a manner that each strip extends over at least one of said at least two bond pads and is connected thereto.

The inventors have found that by using elongated connecting strips spaced apart from each other at a certain distance, room is made available for the solder fillet for connecting the clip to the bonding pads.

It is clear from the wording provided above, that the at least two bond pads are to be electrically connected to each other. As such, the corresponding at least one pin for mounting the semiconductor package to an external board are not electrically isolated. These pins are electrically connected to each other. This allows for one electrically conducting clip to be used for connecting to the at least two bond pads.

Following the above, the inventors have found that it is useful to provide gaps between the elongated connecting strips for allowing the solder, for mounting the elongated connecting strips to the corresponding bond pads, to cure. That is, these gaps may be used to form a solder fillet.

As such, each of the elongated connecting strips, i.e. each finger, is connected / mounted individually to a corresponding bond pad. This in contrast to prior art solutions in which on metallic part is used for connecting all bond pads. The individual connection method makes the connection more resilient and longer lasting.

Each elongated connecting strip extends over its corresponding bond pad. This also encompasses the situation in which the elongated connecting strip overextends to beyond the corresponding bond pad.

As mentioned before the connecting strips may be connected to their corresponding bond pads using solder paste, conducting glue or any other suitable means.

The present disclosure is especially useful for situations in which there are more than two bond pads, as in that case the elongated strips provided in the middle benefit from having air gaps at both sides thereof. These air gaps may be used for the solder fillet or paste fillet or anything alike.

It is noted that, in accordance with the present disclosure, it is not required that the same number of pins as bonding pads are present in the semiconductor package.

In an example, the length of each of said elongated strips, in a longitudinal direction of said strips, is larger than a dimension of said bond pads seen in said longitudinal direction.

The above entails that each of the elongated strips extend to beyond its corresponding bond pad. This ensures that the full bond pad is utilized when connecting the corresponding strip. It is noted that, in this regard, the width of the strip may be tuned to the width of the corresponding bond pad.

In a further example, the clip comprises a bridge portion connecting free ends of said at least two elongated connecting strips to one another.

The bridge portion may thus be free from the corresponding bond pads. The bridge portion is used for connecting the ends of the elongated connecting strips to one another.

One of the advantages of the above is that this allows for solder surface tension to be controlled. Another advantage is that the coplanarity of the connecting strips is controlled during a stamping process. This is explained in more detail with reference to the figures.

In a further example, the bridge portion is elevated with respect to a part of said elongated connecting strips with which respective part said elongated connecting strips are connected to said corresponding bond pads.

With the above described design, a segmented clip with individual downsets are provided that match with the individual bond pads.

In addition, due to potential unbalanced distribution of solder on the fingers, brought by different surface tensions generated at the tip of the individual leads and the ankle of the leads, excessive solder will be highly likely which will result to unbalance surface tensions on clips.

By adding an extension at the tips of the leads, the surface tension will be distributed symmetrically. That is, by adding the bridge portion, the surface tension is distributed symmetrically.

By making the extensions, i.e. fingers, fused together, the leads coplanarity will be better as each leads will protect each other.

Elevated means that the bridge portion is provided at a distance from the semiconductor die, and thus not necessarily contact the semiconductor die. The strips contact the semiconductor die via its bond pads.

In a further example, the bridge portion is provided at a distance from said bond pads seen in a longitudinal direction of said connecting strips.

The strips may thus overextend to beyond the bond pads.

In a further example, the at least two elongated connecting strips extend parallel to one another.

It is noted that multiple connecting strips may extend parallel to one another. It is further noted that the distances between the different connecting strips do not need to be homogeneous, the distances may be heterogeneous. The distances may depend on the size of the bond pad.

In a further example, length of said elongated strips is between 1,5x - 4x larger than said dimension of said bond pads, in said longitudinal direction.

In another example, the semiconductor die is a Field Effect Transistor, FET, and wherein said at least two bond pads are at least two drain bond pads of said FET or wherein the semiconductor die is a High-Electron-Mobility Transistor, HEMT, and wherein said at least two bond pads are at least two drain bond pads of said HEMT.

In yet another example, each strip extends over and connects to exactly one of said at least two bond pads.

In an example, strip comprises a base part in between said connecting portion and said at least one pin, wherein said base part is elevated with respect to a part of said elongated connecting strips with which respective part said elongated connecting strips are connected to said corresponding bond pads.

In another example, the width of each of said at least two elongated strips correspond to a width of each of said at least two bond pads.

In a second aspect of the present disclosure, there is provided a method for assembling a semiconductor package in accordance with any of the previous examples, wherein said method comprises the steps of:
- providing a semiconductor die having multiple bond pads;
- providing an electrically conducting clip, wherein said clip comprises, at a first side thereof, at least one pin for mounting said package to an external board and comprises, at a second side opposite to said first side, a connecting portion connecting said clip to at least two bond pads of said multiple bond pads, said connection portion comprising at least two elongated connecting strips spaced apart from each other at a distance in such a manner that each strip extends over at least one of said at least two bond pads and is connected thereto.

It is noted that the advantages as explained with reference to the first aspect of the present disclosure, being the semiconductor package, are also applicable to the second aspect of the present disclosure, being the method to manufacture such a semiconductor package.

It is further noted that the present disclosure is especially suitable for a semiconductor die being any of a MOSFET or a GaN HEMT.

The above and other aspects of the disclosure will be apparent from and elucidated with reference to the examples described hereinafter.

### Brief description of the drawings

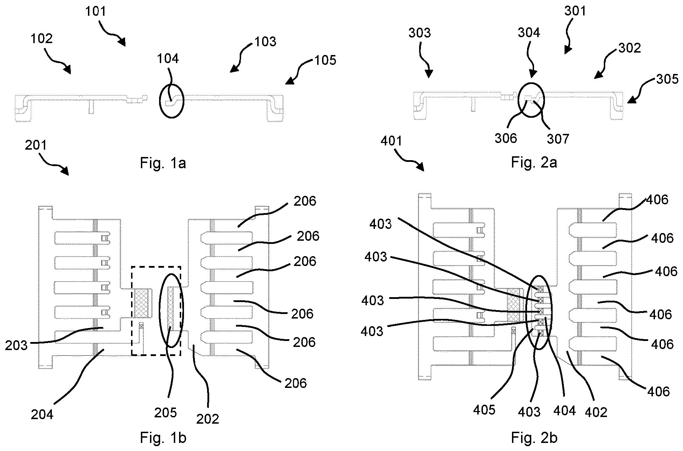

Fig. 1a discloses a side view of a clip that is used for connecting to a bond pad of a semiconductor die in accordance with the prior art;
Fig. 1 b discloses a top view of a semiconductor package having the clip shown in figure 1a, in accordance with the prior art;
Fig. 2a discloses a side view of a clip that is used for connecting to a bond pad of a semiconductor die, in accordance with the present disclosure;
Fig. 2b discloses a top view of a semiconductor package having the clip shown in fig 2a, in accordance with the present disclosure;
Fig. 3 discloses a flow chart of a method in accordance with the present disclosure.

### Detailed description

It is noted that in the description of the figures, same reference numerals refer to the same or similar components performing a same or essentially similar function.

A more detailed description is made with reference to particular examples, some of which are illustrated in the appended drawings, such that the manner in which the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

In the below, the present disclosure is being discussed with respect to a semiconductor die being either a Field Effect Transistor, FET, or a High-Electron-Mobility Transistor, HEMT. As such, three terminals are present on the semiconductor die - a gate terminal, a source terminal and a drain terminal. The gate terminal is used for providing a voltage to the semiconductor die. The semiconductor die is arranged to support a relatively large current between the drain terminal and the source terminal.

The above is one of the reasons why the semiconductor package has one pin that is connected to the gate terminal, while the semiconductor package has at least one pin for the source terminal as well as at least one pin for the drain terminal. The at least one pin may be required for supporting the relatively large current.

Figure 1a discloses a side view of clips 101 that are used for connecting to bond pads of an semiconductor die in accordance with the prior art. Figure 1a discloses two clips, i.e. having reference numerals 102 and 103.

The clip having reference numeral 102 is used for connecting to the source bond pad of the semiconductor die, and the clip having reference numeral 103 is used for connecting to the drain bond pad of the semiconductor die.

Reference numeral 104 shows the part of the clip that is used for mounting to the drain pad of the semiconductor die. As shown, the clip steps down from a base part, wherein the stepped down part of the clip is soldered to the drain bond pad of the semiconductor die. Reference numeral 105 shows the other end of the clip, wherein the other end is used as the pins of the semiconductor package.

Following the above, the clips 102, 103 comprise a conductive material such that they are able to conduct a current.

Figure 1b discloses a top view 201 of a semiconductor package having the clip shown in figure 1a, in accordance with the prior art. The clip having reference numeral 202 is used for connecting to the drain bond pad of the semiconductor die. The clip having reference numeral 203 is used for connecting to the source bond pad of the semiconductor die. The clip having reference numeral 204 is used for connecting to the gate bond pad of the semiconductor die.

The clip 202 that is used for connecting to the drain bond pad of the semiconductor die has a first part 205 that is mounted to the drain bond pad, and has a second part 206, opposite to the first part 205, that is used as the pins of the package. The pins are used for mounting the semiconductor package to an external board, for example a Printed Circuit Board, PCB.

Figure 2a discloses a side view of clips 301 that are used for connecting to bond pads of a semiconductor die, in accordance with the present disclosure.

The clip that is used for connecting to the drain bond pad of the semiconductor die has reference numeral 302. The clip that is used for connecting to the source bond pad of the semiconductor die has reference numeral 303. The present disclosure is elaborated with respect to the clip 302 for connecting to the drain bond pad of the semiconductor die.

The electrically conducting clip 301 comprises, at a first side thereof 305, at least one pin for mounting the package to an external board and comprises, at a second side 304 opposite to the first side 305, a connecting portion connecting said clip to at least two bond pads of said multiple bond pads.

The connection portion comprising at least two elongated connecting strips spaced apart from each other at a distance in such a manner that each strip extends over at least one of said at least two bond pads and is connected thereto. This is explained in more detail with respect to figure 2b.

It is noted that the clip 302 is mounted to the corresponding drain bond pad via the connection portion as indicated with reference numeral 307. The connection portion comprises multiple parallelly extending fingers. The inventors have found that it may be beneficial for connecting those fingers, at the free end thereof, to each other. One of the benefits relates to surface tension.

The above is accomplished by the bridge portion as indicated with reference numeral 306. The bridge portion 306 connects the free ends of the elongated connecting strips 307 to one another.

As shown in figure 2a, the bridge portion 306 is elevated with respect to the elongated connecting strips 307.This may ensure that the bridge portion 306 is noted directly connected to the respective bond pad using solder or the like. Another advantage is that this provides room for the solder fillet for connecting the strips 307 to the respective bond pads.

The bridge portion 306 is thus provided at a certain distance from said bond pads seen in a longitudinal direction of said connecting strips. The bridge portion 306 is thus not oriented above the respective bond pad, but is, from a top view, oriented next to the respective bond pad. This is shown more clearly in figure 2b.

Figure 2b discloses a top view 401 of a semiconductor package having the clips shown in fig 2a, in accordance with the present disclosure.

Reference is made to the clip 402 that connects to the drain bond pads of the semiconductor die.

In this particular case, the semiconductor die has multiple drain pads. This is shown by the reference numeral 403. More specifically, the drain bond pads 403 are aligned in a particular row. In this particular case, five individual drain bond pads 403 are provided on the semiconductor die.

One of the aspects of the present disclosure is to provide segmented clips to fit with the segmented / individual bond pads 403. The segmented clips will have its own downsets to match up with the size of the bond pads, ensuring solderable top metal of bond pads to Cu gaps are enough to form a solder fillet. The downsets are considered as the connection portion of the clip 402.

The lead tips of the segmented clips with downsets may have an extension to overhang with respect to the drain pads, in which these extended leads may be fused together to control solder surface tension as well as the coplanarity of each drain leads downset during stamping process. This is shown by the bridge portion 405 in figure 2b and having reference numeral 306 in figure 2a.

Figure 2b shows a uniform distance between each of the bond pads 403. Further, the connecting strips are spaced apart from each other at this particular distance in such a manner that each strip extends over its corresponding bond pad and is connected thereto. Reference numeral 404 thus indicates a cut out in the clip. The cut out itself is also elongatedd in shape. The cut out allows solder to flow for firmly connecting the strips to the corresponding bond pads.

Reference numeral 406 indicates the pins of the semiconductor package for mounting the semiconductor package to an external board, for example a Printed Circuit Board, PCB.

Following the above, different from the prior art situation as shown in figures 1a and 1b, the bond pads are individually connected by the different strips / fingers. Further, an elevated bridge portion is provided for connecting the different strips together to mitigate and surface tension. This improves the life expectancy of the connection between the bond pad and the clip 402.

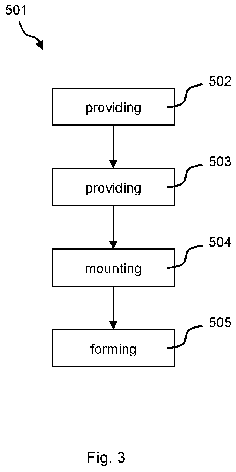

Fig. 3 discloses a flow chart of a method 501 in accordance with the present disclosure.

The method 501 is for assembling a semiconductor package in accordance with any of the previous examples, wherein said method comprises the steps of:
- providing 502 a semiconductor die having multiple bond pads;
- providing 503 an electrically conducting clip, wherein said clip comprises, at a first side thereof, at least one pin for mounting said package to an external board and comprises, at a second side opposite to said first side, a connecting portion connecting said clip to at least two bond pads of said multiple bond pads, said connection portion comprising at least two elongated connecting strips spaced apart from each other at a distance in such a manner that each strip extends over at least one of said at least two bond pads and is connected thereto.
- mounting 504 the electrically conducting clip on top of the semiconductor die by using, for example, a soldering process.
- Finally, the end of the clip is trimmed to form the pins of the semiconductor package.

The ensuing description above provides preferred exemplary embodiment(s) only, and is not intended to limit the scope, applicability or configuration of the invention. Rather, the ensuing description of the preferred exemplary embodiment(s) will provide those skilled in the art with an enabling description for implementing a preferred exemplary embodiment of the invention, it being understood that various changes may be made in the function and arrangement of elements, including combinations of features from different embodiments, without departing from the scope of the invention.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or," in reference to a list of two or more items, covers all of the following interpretations of the word: any of the items in the list, all of the items in the list, and any combination of the items in the list.

In the description above, for the purposes of explanation, numerous specific details are set forth in order to provide a thorough understanding of implementations of the disclosed technology. It will be apparent, however, to one skilled in the art that embodiments of the disclosed technology may be practiced without some of these specific details.

## Claims

1. A semiconductor package comprising a semiconductor die having multiple bond pads, said package further comprising an electrically conducting clip, wherein said clip comprises, at a first side thereof, at least one pin for mounting said package to an external board and comprises, at a second side opposite to said first side, a connecting portion connecting said clip to at least two bond pads of said multiple bond pads, said connection portion comprising:
- at least two elongated connecting strips spaced apart from each other at a distance in such a manner that each strip extends over at least one of said at least two bond pads and is connected thereto.

2. A semiconductor package in accordance with claim 1, wherein a length of each of said elongated strips, in a longitudinal direction of said strips, is larger than a dimension of said bond pads seen in said longitudinal direction.

3. A semiconductor package in accordance with any of the previous claims, wherein said clip comprises a bridge portion connecting free ends of said at least two elongated connecting strips to one another.

4. A semiconductor package in accordance with claim 3, wherein said bridge portion is elevated with respect to a part of said elongated connecting strips with which respective part said elongated connecting strips are connected to said corresponding bond pads.

5. A semiconductor package in accordance with any of the claims 3 - 4, wherein said bridge portion is provided at a distance from said bond pads seen in a longitudinal direction of said connecting strips.

6. A semiconductor package in accordance with any of the previous claims, wherein said at least two elongated connecting strips extend parallel to one another.

7. A semiconductor package in accordance with claim 2, wherein said length of said elongated strips is between 1,5x- 4x larger than said dimension of said bond pads, in said longitudinal direction.

8. A semiconductor package in accordance with any of the previous claims, wherein semiconductor die is any of:
- a Field Effect Transistor, FET, wherein said at least two bond pads are at least two drain bond pads of said FET;
- a High-Electron-Mobility Transistor, HEMT, wherein said at least two bond pads are at least two drain bond pads of said HEMT.

9. A semiconductor package in accordance with any of the previous claims, wherein each strip extends over and connects to exactly one of said at least two bond pads.

10. A semiconductor package in accordance with any of the previous claims, wherein said strip comprises a base part in between said connecting portion and said at least one pin, wherein said base part is elevated with respect to a part of said elongated connecting strips with which respective part said elongated connecting strips are connected to said corresponding bond pads.

11. A semiconductor package in accordance with any of the previous claims, wherein a width of each of said at least two elongated strips correspond to a width of each of said at least two bond pads.

12. A method for assembling a semiconductor package in accordance with any of the previous claims, wherein said method comprises the steps of:
- providing a semiconductor die having multiple bond pads;
- providing an electrically conducting clip, wherein said clip comprises, at a first side thereof, at least one pin for mounting said package to an external board and comprises, at a second side opposite to said first side, a connecting portion connecting said clip to at least two bond pads of said multiple bond pads, said connection portion comprising at least two elongated connecting strips spaced apart from each other at a distance in such a manner that each strip extends over at least one of said at least two bond pads and is connected thereto.
